Europäisches Patentamt

European Patent Office

Office européen des brevets

(19)

(11) **EP 1 424 722 A1**

(12) **EUROPÄISCHE PATENTANMELDUNG**

(43) Veröffentlichungstag:
**02.06.2004 Patentblatt 2004/23**

(51) Int Cl.⁷: **H01L 21/00**, H05K 13/04

(21) Anmeldenummer: **02080020.7**

(22) Anmeldetag: **29.11.2002**

(84) Benannte Vertragsstaaten:
**AT BE BG CH CY CZ DE DK EE ES FI FR GB GR IE IT LI LU MC NL PT SE SK TR**
Benannte Erstreckungsstaaten:
**AL LT LV MK RO SI**

(71) Anmelder: **Esec Trading S.A.**
**6330 Cham (CH)**

(72) Erfinder:
• **Mannhart, Eugen, Dr.**
**6330 Cham (CH)**

• **Bolliger, Daniel, Dr.**
**6003 Luzern (CH)**
• **Leu, Felix**
**6300 Zug (CH)**
• **Hartmann, Dominik**
**6332 Hagendorn (CH)**

(74) Vertreter: **Falk, Urs, Dr.**
**Patentanwaltsbüro Dr. Urs Falk,**
**Eichholzweg 9A**
**6312 Steinhausen (CH)**

(54) **Verfahren zum Aufnehmen von Halbleiterchips von einer Folie und Vorrichtung**

(57) Das Aufnehmen eines Halbleiterchips (19) von einer Folie (18) erfolgt mittels eines Chipgreifers (2), der an einem Bondkopf (1) in einer vorbestimmten Richtung auslenkbar gelagert ist, und mit Unterstützung einer Nadel (14). Ein induktive Sensor dient für die präzise Messung der Auslenkung des Chipgreifers bezüglich des Bondkopfs (1). Der Pick Prozess zeichnet sich durch die folgenden Schritte aus:

a) Absenken des Chipgreifers (2) auf eine Höhe $z_0$, die grösser ist als eine mittlere Höhe der Oberfläche der Halbleiterchips (19), damit der Chipgreifer (2) den Halbleiterchip (19) noch nicht berührt,
b) Anheben der Nadel (14) auf eine vorbestimmte Höhe $z_1$, wobei die Nadel (14) den Halbleiterchip (19) anhebt, um den Halbleiterchip (19) in Kontakt mit dem Chipgreifer (2) zu bringen und dann die Höhe des Chipgreifers (2) zu erhöhen, und
c) Anheben des Chipgreifers (2), wobei sich der Halbleiterchip (19) von der Nadel (14) löst.

Fig. 1

**Beschreibung**

Die Erfindung betrifft ein Verfahren und eine Vorrichtung zum Aufnehmen von Halbleiterchips von einer Folie der im Oberbegriff des Anspruchs 1 genannten Art.

Bei der Montage von Halbleiterchips auf ein Substrat wird das Substrat von einer Transporteinrichtung taktweise einer Dispensstation, wo Klebstoff aufgetragen wird, und dann einer Bondstation zugeführt, wo der nächste Halbleiterchip plaziert wird. Die Halbleiterchips haften auf einer auf einen Rahmen aufgespannten Folie und werden auf einem sogenannten Wafertisch bereitgestellt, dort einer nach dem andern von einer als Pick and Place bekannten Einrichtung aufgenommen, transportiert und auf dem Substrat abgesetzt. Die Pick and Place Einrichtung umfasst einen Bondkopf mit einem Chipgreifer zur Aufnahme des Halbleiterchips, wobei der Chipgreifer in vertikaler Richtung gegenüber dem Bondkopf entgegen einer Kraft, der sogenannten Pickkraft beim Aufnehmen von der Folie bzw. Bondkraft beim Plazieren auf dem Substrat, auslenkbar ist. Das Aufnehmen und Ablösen des Halbleiterchips von der Folie wie auch das Plazieren des Halbleiterchips auf dem Substrat sind difficile Prozesse. Beim Aufnehmen des Halbleiterchips stellt sich das Problem, dass sich dessen Oberfläche nicht immer auf der gleichen Höhe befindet und dass daher nicht bekannt ist, auf welcher Höhe der Chipgreifer zum Stillstand kommen soll. Einerseits soll der Chipgreifer mit möglichst grosser Geschwindigkeit abgesenkt werden, damit die Zykluszeit möglichst kurz bleibt. Andererseits soll der Chipgreifer mit möglichst kleinem Impuls und damit kleiner Geschwindigkeit auf dem Halbleiterchip auftreffen, damit der Halbleiterchip nicht beschädigt wird.

Es sind heutzutage zwei Verfahren bekannt, um die als z-Höhe bezeichnete Höhe der Oberfläche der Halbleiterchips, die sich auf der Folie befinden, bzw. der Höhe der Oberfläche der Substrate zu bestimmen. Beim ersten Verfahren wird am Bondkopf anstelle des Chipgreifers ein Messkopf installiert, mit dem sich die z-Höhe, bei der der Messkopf auf den Halbleiterchip bzw. das Substrat auftrifft, messen lässt. Beim zweiten Verfahren wird der Strom, der durch den den Bondkopf absenkenden Antrieb fliesst, überwacht und eine plötzliche Zunahme dieses Stromes als Auftreffen des Chipgreifers auf den Halbleiterchip bzw. das Substrat interpretiert.

Der Erfindung liegt die Aufgabe zugrunde, den Prozess für das Aufnehmen der Halbleiterchips von der Folie weiter zu verbessern.

Die genannte Aufgabe wird erfindungsgemäss gelöst durch die Merkmale der Ansprüche 1 und 8.

Das Aufnehmen eines Halbleiterchips von einer Folie erfolgt mittels eines Chipgreifers, der an einem Bondkopf in einer vorbestimmten, als z-Richtung bezeichneten Richtung auslenkbar ist, und mit Unterstützung einer Nadel. Der Chipgreifer ist pneumatisch am Bondkopf gelagert, so dass die vom Chipgreifer auf den Halbleiterchip ausgeübte Pickkraft unabhängig vom Grad der Auslenkung des Chipgreifers ist. Zudem ist im Bondkopf ein induktiver Sensor integriert für die präzise Messung der Auslenkung des Chipgreifers in z-Richtung, d.h. der z-Höhe des Chipgreifers. Der induktive Sensor dient auch als Touch Down Sensor.

Der erfindungsgemässe Pick Prozess zeichnet sich durch die folgenden Schritte aus:

a) Absenken des Chipgreifers auf eine Höhe $z_0$, die grösser ist als die mittlere Höhe der Oberfläche der Halbleiterchips, damit der Chipgreifer den Halbleiterchip noch nicht berührt;

b) Anheben der Nadel auf eine vorbestimmte Höhe $z_1$, wobei die Nadel den Halbleiterchip anhebt, um den Halbleiterchip in Kontakt mit dem Chipgreifer zu bringen und dann die z-Lage des Chipgreifers zu erhöhen, und

c) Anheben des Chipgreifers, wobei sich der Halbleiterchip von der Nadel löst.

Die Höhe $z_0$ wird jeweils dann, wenn eine neue Folie mit Halbleiterchips zur Abarbeitung bereitgestellt wird, in einer Justierphase mit Hilfe des induktiven Sensors neu bestimmt. Die Höhe wird auch als z-Position bezeichnet.

Bei gewissen Anwendungen wird zudem beim Schritt c der Chipgreifer mit möglichst grosser Geschwindigkeit von der Nadel wegbewegt, um eine Drehung und/oder Verschiebung des Halbleiterchips zu vermeiden.

Des weiteren ist es möglich, die Auslenkung des Chipgreifers gegenüber dem Bondkopf nach dem Schritt b zu messen und daraus die tatsächliche Höhe der Oberfläche des aufgenommenen Halbleiterchips zu bestimmen, um die Höhe $z_0$ laufend oder periodisch zu aktualisieren.

Weil der induktive Sensor im Bondkopf integriert ist, kann die Höhe $z_0$ mit sehr grosser Genauigkeit bestimmt werden. Darum ist es auch möglich, im Schritt a den Bondkopf auf eine Höhe $z_0$ abzusenken, die kleiner ist als die mittlere Höhe $z_M$ der Oberfläche der Halbleiterchips, so dass der Chipgreifer beim Auftreffen auf den Halbleiterchip gegenüber dem Bondkopf ausgelenkt wird. Eine hinreichende Bedingung ist allerdings, dass der Chipgreifer pneumatisch am Bondkopf gelagert ist. Die Distanz, um die die Höhe $z_0$ in diesem Fall kleiner ist als die Höhe $z_M$, die als sogenannte Overtraveldistanz bezeichnet wird, kann einerseits wegen der genauen Kenntnis der Höhe $z_M$ und andererseits wegen der pneumatischen Lagerung des Chipgreifers, die eine vom Grad der Auslenkung unabhängige Kraft liefert, viel kleiner als im Stand der Technik üblich gehalten werden. Somit befindet sich der Bondkopf bereits unmittelbar vor dem Ende der Bremsphase, wenn der Chipgreifer auf den Halbleiterchip auftrifft. Demzufolge ist die Auftreffgeschwindigkeit des Chipgreifers und damit der Aufprall auf den Halbleiterchip geringer als im Stand der Technik.

Nachfolgend werden Ausführungsbeispiele der Erfindung anhand der Zeichnung näher erläutert. Die Darstellung der Figuren ist schematisch und nicht massstäblich.

Es zeigen:

Fig. 1      ein erstes Ausführungsbeispiel eines Bondkopfs eines Die Bonders, der einen integrierten Touch Down Sensor aufweist,

Fig. 2      eine Kennlinie des Touch Down Sensors,

Fig. 3      ein Diagramm,

Fig. 4A-C   Momentaufnahmen des Bondkopfs,

Fig. 5      ein Diagramm,

Fig. 6      ein zweites Ausführungsbeispiel eines Bondkopfs eines Die Bonders, und

Fig. 7      ein Diagramm.

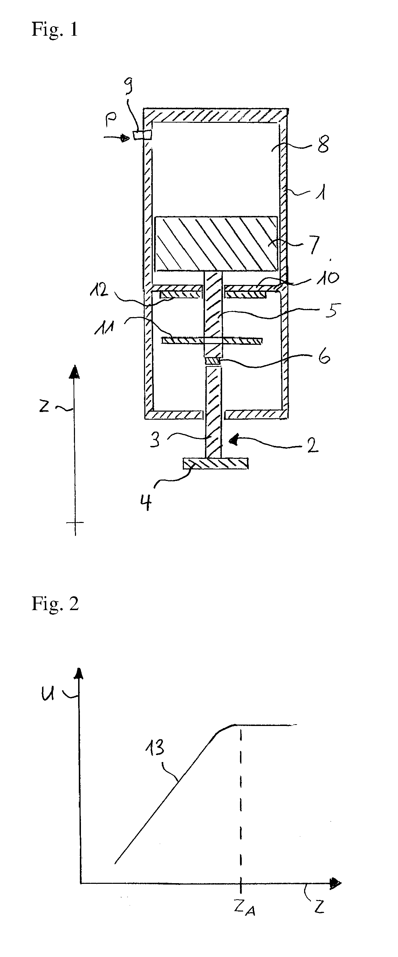

Die Fig. 1 zeigt ein erstes Ausführungsbeispiel eines Bondkopfs 1 eines Die Bonders, wobei nur diejenigen Bestandteile des Bondkopfs 1 dargestellt und beschrieben sind, die für das Verständnis der Erfindung nötig sind. Der Bondkopf 1 gehört zu einem Pick und Placesystem, das dazu dient, auf einem Wafertisch bereitgestellte Halbleiterchips aufzunehmen und auf einem Substrat zu platzieren. Bei diesem Ausführungsbeispiel wird der Bondkopf 1 für das Aufnehmen des Halbleiterchips in einer als z-Richtung bezeichneten Richtung abgesenkt, wieder angehoben, zum Substrat transportiert und zum Platzieren des Halbleiterchips auf dem Substrat wieder abgesenkt. Für die präzise Bewegung des Bondkopfs 1 in z-Richtung sind ein nicht dargestellter Antrieb und ein nicht dargestelltes Messsystem für die Messung der z-Lage des Bondkopfs 1 vorhanden. Der Antrieb kann entweder den Bondkopf 1 bezüglich des Pickund Placesystems in z-Richtung absenken und anheben oder er kann das ganze Pick- und Placesystems zusammen mit dem Bondkopf 1 in z-Richtung absenken und anheben. Ein solches Pick- und Placesystem ist beispielsweise aus der europäischen Patentanmeldung EP 923 111 bekannt. Der Bondkopf 1 umfasst einen Chipgreifer 2, der gegenüber dem Bondkopf 1 in der z-Richtung auslenkbar ist. Der Chipgreifer 2 besteht aus einem Metallschaft 3, an dessen unterem Ende ein mit Vakuum beaufschlagbares Saugorgan 4 befestigt ist. Der Chipgreifer 2 ist im Bondkopf 1 pneumatisch, möglichst reibungsfrei, gelagert. Der Bondkopf 1 weist einen in der z-Richtung bewegbaren Schaft 5 auf, an dessen unterem Ende ein Magnet 6 befestigt ist, so dass der Chipgreifer 2 mittels Magnetkraft am Bondkopf 1 befestigt ist und auf einfache Weise ausgewechselt werden kann. Das obere Ende des Schafts 5 ist an einem Kolben 7 befestigt, der in einer zylinderförmigen Druckkammer 8 geführt ist. Die Druckkammer 8 ist über einen Anschlus 9 mit einem vorbestimmten Druck p, sowohl mit Überdruck als auch Unterdruck/Vakuum, beaufschlagbar. Die pneumatische Lagerung des Chipgreifers 2 am Bondkopf 1 erzeugt eine vom Grad der Auslenkung des Chipgreifers 1 unabhängige Pickkraft. Wenn die Druckkammer 8 mit Überdruck beaufschlagt wird, dann wird der Kolben 7 gegen die als Anschlag dienende Wand 10 gedrückt. Diese Endlage des Kolbens 7 und somit auch des Chipgreifers 2 wird als Ruhelage des Chipgreifers 2 bezeichnet, in der der Chipgreifer 2 gegenüber dem Bondkopf 1 nicht ausgelenkt ist.

Der Bondkopf 1 weist einen integrierten, als Touch Down Sensor bezeichneten Sensor auf, der aus einer Platte 11 aus Metall, beispielsweise aus Aluminium, und einer elektrischen Spule 12 besteht. Die Spule 12, vorzugsweise eine auf einer Leiterplatte durch eine spiralförmig verlaufende Leiterbahn gebildete Flachspule, ist am Bondkopf 1 befestigt. Die Platte 11 ist am Schaft 5 befestigt. Das Ausgangssignal des induktiven Sensors ist proportional zum Abstand zwischen der Platte 11 und der Spule 12. Wenn der Chipgreifer 2 gegenüber dem Bondkopf 1 ausgelenkt wird, dann bewegt sich die Platte 11 mit dem Chipgreifer 2 mit, während sich die Lage der Spule 12 nicht verändert. Der Abstand zwischen der Platte 11 und der Spule 12 verkleinert sich somit entsprechend dem Grad der Auslenkung. Der Schaft 5 ist fakultativ um seine Längsachse drehbar, damit eine allfällige Verdrehung des Halbleiterchips vor dem Platzieren auf dem Substrat korrigiert werden kann.

Die Integration des Touch Down Sensors auf dem Bondkopf in Kombination mit der pneumatischen Lagerung des Chipgreifers am Bondkopf bietet Vorteile, die sich sowohl beim Aufnehmen des Halbleiterchips von der Folie als auch beim Plazieren des Halbleiterchips auf dem Substrat auswirken. Im Folgenden werden nun verschiedene Verfahren näher erläutert, die die Aufnahme des Halbleiterchips von der Folie betreffen.

Bei diesen Verfahren ist in der Regel eine Justierphase und eine Betriebsphase vorgesehen. Immer dann, wenn auf dem Wafertisch eine neue Folie mit Halbleiterchips für die Abarbeitung bereitgestellt wird, wird die Betriebsphase unterbrochen und in einer Justierphase die z-Höhe der Oberfläche der Halbleiterchips ermittelt. Es wird also zunächst ein Justierverfahren durchgeführt, um eine Höhe $z_M$ zu ermitteln, die der z-Höhe der Oberfläche der Halbleiterchips entspricht. Aus der Höhe $z_M$ wird eine Höhe $z_0$ abgeleitet, die in der Betriebsphase als Parameter für das Absenken des Bondkopfs dient und eine optimale z-Bewegung des Bondkopfs ermöglicht. Dieses Justierverfahren umfasst die folgenden Schritte:

a) Es wird ein Halbleiterchip auf der Folie ausgewählt und der Wafertisch in eine Position gebracht, in der sich der ausgewählte Halbleiterchip unterhalb des Chipgreifers 2 befindet.

b) Der Bondkopf 1 wird auf eine vorbestimmte z-Höhe abgesenkt, bei der der Chipgreifer 2 den Halbleiterchip noch nicht berührt. Die Druckkammer 8 wird mit einem Überdruck beaufschlagt, so dass der Kolben 7 auf der Wand 10 der Druckkammer 8 aufliegt. Der Chipgreifer 2 befindet sich also in seiner Ruhelage. Der Überdruck entspricht beispielsweise der während der nachfolgenden Produktionsphase gewünschten Pickkraft. Das Ausgangssignal U des induktiven Sensors ist konstant.

c) Der Bondkopf 1 wird nun mit konstanter Geschwindigkeit abgesenkt. Sobald der Chipgreifer 2 auf den Halbleiterchip auftrifft, bleibt der Chipgreifer 2 stehen, während der Bondkopf 1 noch weiter absinkt. Der Chipgreifer 2 wird also gegenüber dem Bondkopf 1 ausgelenkt, wobei sich der Abstand zwischen der Platte 11 und der Spule 12 des induktiven Sensors verringert. Während dieser Phase c werden laufend die z-Höhe des Bondkopfs 1 und das Ausgangssignal U des induktiven Sensors ermittelt und als Wertepaare $(z;, U_i)$ gespeichert, wobei der Index i eine ganze Zahl bedeutet.

d) Sobald das Ausgangssignal des induktiven Sensors einen vorbestimmten Wert erreicht, wird das Absenken des Bondkopfs 1 gestoppt und der Bondkopf 1 wieder angehoben.

e) Die Wertepaare $(z_i, U_i)$ bilden eine Kennlinie 13, die typischerweise den in der Fig. 2 dargestellten Verlauf aufweist. Aus den Wertepaaren $(z_i, U_i)$ wird nun mit üblichen mathematischen Methoden die Höhe $z_M$ bestimmt.

Die Höhe z, bei der der Chipgreifer 2 physikalisch in Kontakt kommt mit dem Halbleiterchip, ist als Höhe $z_A$ bezeichnet. Aus der Fig. 2 ist ersichtlich, dass das Ausgangssignal U nicht unmittelbar ab der Höhe $z_A$ abnimmt, sondern erst etwas später, weil das Saugorgan 4 selbst etwas einfedert und die Auslenkung des Chipgreifers 2 gegenüber dem Bondkopf 1 erst nachher beginnt. Die Krümmung der Kennlinie 13 im Bereich des Touch Downs ist charakteristisch für den Typ des verwendeten Saugorgans 4. Es ist deshalb bevorzugt vorgesehen, für jeden Typ der Saugorgane eine Korrekturgrösse $z_k$ zu ermitteln und auf dem Die Bonder abzuspeichern, so dass bei der Bestimmung der Höhe $z_M$ aus den Wertepaaren $(z_i, U_i)$ dank der Kenntnis der Korrekturgrüsse $z_k$ die tatsächliche physikalische Höhe $z_A$ der Oberseite des Halbleiterchips berechnet werden kann.

Das Justierverfahren wird bevorzugt für mehrere verschiedene Halbleiterchips durchgeführt, um anschliessend eine die Höhe der Oberfläche der Halbleiterchips auf der Folie besser charakterisierende, gemittelte Höhe zu bestimmen, die hier ebenfalls als Höhe $z_M$ bezeichnet wird.

Im Folgenden wird ein vereinfachtes Justierverfahren erläutert, um die mittlere z-Höhe der Oberfläche der Halbleiterchips zu bestimmen:

a) Es wird ein Halbleiterchip auf der Folie ausgewählt und der Wafertisch in eine Position gebracht, in der sich der ausgewählte Halbleiterchip unterhalb des Chipgreifers 2 befindet.

b) Der Bondkopf 1 wird auf eine vorbestimmte z-Höhe abgesenkt, bei der der Chipgreifer 2 den Halbleiterchip noch nicht berührt. Die Druckkammer 8 wird mit einem Überdruck beaufschlagt, so dass sich der Chipgreifer 2 in seiner Ruhelage befindet, in der der Kolben 7 auf der Wand 10 der Druckkammer 8 aufliegt. Der Überdruck entspricht beispielsweise der während der nachfolgenden Produktionsphase gewünschten Pickkraft. Das Ausgangssignal U des induktiven Sensors wird als Wert $U_0$ gespeichert.

c) Der Bondkopf 1 wird nun mit konstanter Geschwindigkeit abgesenkt. Sobald der Chipgreifer 2 auf den Halbleiterchip auftrifft, bleibt der Chipgreifer 2 stehen, während der Bondkopf 1 noch weiter absinkt. Das Ausgangssignal U des induktiven Sensors nimmt daher kontinuierlich ab. Wenn das Ausgangssignal U den Wert $U_1=U_0-\Delta U$ erreicht, wird die z-Höhe des Bondkopfs 1 als Höhe $z_J$ ausgelesen, das Absenken des Bondkopfs 1 gestoppt und der Bondkopf 1 wieder angehoben.

d) Aus der Höhe $z_J$ und dem Wert $\Delta U$ wird unter Berücksichtigung der Kennlinie 13 des Sensors die z-Höhe der Oberfläche des Halbleiterchips bestimmt.

Das vereinfachte Justierverfahren wird bevorzugt für mehrere Halbleiterchips durchgeführt und dann die mittlere Höhe $z_M$ der Oberfläche des Halbleiterchips bestimmt.

Aus der mittleren Höhe $z_M$ wird anschliessend eine Höhe $z_0$ abgeleitet. Die aus der Höhe $z_M$ abgeleitete Höhe $z_0$ wird benutzt, um die Geschwindigkeit des Bondkopfs während des Absenkens bei der nachfolgenden Abarbeitung des Wafers dahingehend zu optimieren, dass die Zeitdauer für das Absenken des Bondkopfs bis zum Stillstand einerseits möglichst kurz ist und dass andererseits der Aufprallimpuls, d.h. der Impuls, mit dem der Chipgreifer auf den Halbleiterchip aufprallt, klein genug ist, um Beschädigungen des Halbleiterchips, des Chipgreifers und/oder der Nadelhalterung auszuschliessen. Die Abarbeitung der Halbleiterchips kann auf verschiedene Weise erfolgen, wobei aber die mittels des Justierverfahrens ermittelte Höhe $z_0$ eine nun näher erläuterte Rolle spielt.

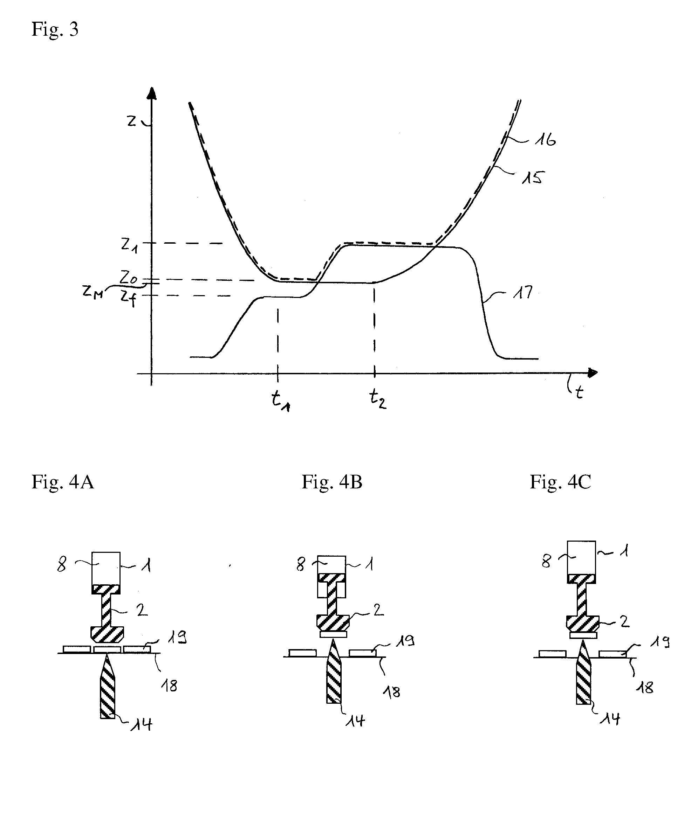

Das Picken des Halbleiterchips von der Folie erfolgt durch das kontrollierte Zusammenwirken von Bondkopf 1, Chipgreifer 2 und einer Nadel oder eines Nadelblocks mit mehreren Nadeln, im folgenden allgemein als Nadel 14 bezeichnet. Die Fig. 3 zeigt für den Pick Prozess die z-Höhe des Bondkopfs 1 (ausgezogene Linie 15), die z-Höhe des Chipgreifers 2 (gestrichelte Linie 16) und die z-Höhe der Nadel 14 (ausgezogene Linie 17) im Laufe der Zeit t. Die Auslenkung des Chipgreifers 2 bezüglich des Bondkopfs 1 ist gleich der Differenz zwischen der ausgezogenen Linie 15 und der gestrichelten Linie 16. Die Fig. 4A bis 4C zeigen verschiedene Momentaufnahmen während des Pick Prozesses. Diese Figuren zeigen auf einer Folie 18 haftende Halbleiterchips 19, die einer nach dem andern zu picken und auf einem Substrat zu platzieren sind, den Bondkopf 1, den Chipgreifer 2 und die Nadel 14. Die Nadel 14 ist Teil eines nicht dargestellten Chipauswerfers (in der Fachwelt als Die-Ejector bekannt). Der Chipauswerfer hält die Unterseite der Folie 18 während des Pick Prozesses mittels Vakuum fest. Bei diesem Beispiel ist die Höhe $z_0$ gegeben durch

$$z_0 = z_M + \Delta z, \qquad (1)$$

wobei der Parameter $\Delta z$ einen positiven Wert hat.

In einer ersten Phase, die bis zum Zeitpunkt $t_1$ dauert, wird der Bondkopf 1 mit maximaler Geschwindigkeit abgesenkt, dabei möglichst spät abgebremst und, ohne den Halbleiterchip 19 zu berühren, auf der Höhe $z_0$ zum Stillstand gebracht. Die Druckkammer 8 wird mit einem vorbestimmten Überdruck beaufschlagt. Der Chipgreifer 2 befindet sich in seiner Ruhelage, da der in der Druckkammer 8 herrschende Überdruck den Kolben 7 gegen die Wand 10 drückt. Der Chipgreifer 2 berührt den Halbleiterchip 19 nicht. Die Nadel 14 wird soweit angehoben, dass sie die Unterseite der Folie 18 gerade berührt. Die z-Höhe der Folie 18 ist mit $z_f$ bezeichnet. Dieser Zustand ist in der Fig. 4A dargestellt.

In einer zweiten Phase, die vom Zeitpunkt $t_1$ bis zum Zeitpunkt $t_2$ dauert, verharrt der Bondkopf 1 auf der Höhe $z_0$. Die Nadel 14 wird mit kontrollierter Geschwindigkeit angehoben, bis sie eine vorbestimmte Höhe $z_1$ erreicht. Dabei durchstösst die Nadel 14 die Folie 18 und hebt den Halbleiterchip 19 an. Der Halbleiterchip 19 kommt dabei zunächst in Kontakt mit dem Chipgreifer 2 und lenkt dann den Chipgreifer 2 gegenüber dem Bondkopf 1 aus: Der Halbleiterchip 19 ist nun zwischen dem Chipgreifer 2 und der Nadel 14 eingeklemmt. Dieser Zustand ist in der Fig. 4B dargestellt. Die vom Chipgreifer 2 auf den Halbleiterchip 19 ausgeübte Pickkraft ist unabhängig vom Grad der Auslenkung des Chipgreifers 2 gegenüber dem Bondkopf 1 und hängt nur von dem in der Druckkammer 8 herrschenden Druck ab. Somit kann die Auslenkung des Chipgreifers 2 vergleichsweise gering gehalten werden. Der Wert des Parameters $\Delta z$ soll einerseits so gross sein, dass der Bondkopf 1 beim Absenken den Halbleiterchip 19 nicht berührt oder wenn er ihn infolge Überschwingens kurzzeitig berührt, dass dann die auf den Halbleiterchip 19 ausgeübte Kraft auf jeden Fall kleiner als die Pickkraft bleibt. Andererseits soll der Parameter $\Delta z$ so klein sein, dass der Halbleiterchip 19 beim Ablösen von der Folie 18 mittels der Nadel 14 nicht kippen kann.

In einer dritten Phase, die am Zeitpunkt $t_2$ beginnt, wird der Bondkopf 1 wieder angehoben und dann in horizontaler Richtung wegbewegt, um den Halbleiterchip 19 auf dem Substrat zu platzieren. Dabei nimmt die Auslenkung des Chipgreifers 2 kontinuierlich ab. Sobald die Auslenkung den Wert Null erreicht hat, wie in der Fig. 4C dargestellt ist, nimmt der Bondkopf 1 den Chipgreifer 2 und den Halbleiterchip 19 nach oben mit.

Bei dem in der Fig. 3 gezeigten Beispiel beginnt die dritte Phase erst, nachdem die Nadel 14 ihre maximale Höhe $z_1$ erreicht hat. Die dritte Phase kann aber auch früher gestartet werden, nämlich sobald die Auslenkung des Chipgreifers 2 einen vorbestimmten minimalen Wert erreicht hat und bevor die Nadel 14 ihre maximale Höhe $z_1$ erreicht hat. Es ist nur darauf zu achten, dass der Chipgreifer 2 gegenüber dem Bondkopf 1 ausgelenkt bleibt, bis die Nadel 14 ihre maximale Höhe $z_1$ erreicht hat. Der Zeitpunkt $t_2$, an dem der Bondkopf 1 wieder angehoben wird, kann entweder als feste Zeit programmiert sein oder aus dem vom Touch Down Sensor während der zweiten Phase gelieferten Signal abgeleitet werden. D.h. der Touch Down Sensor triggert dann den Zeitpunkt $t_2$, an dem der Bondkopf 1 wieder angehoben wird.

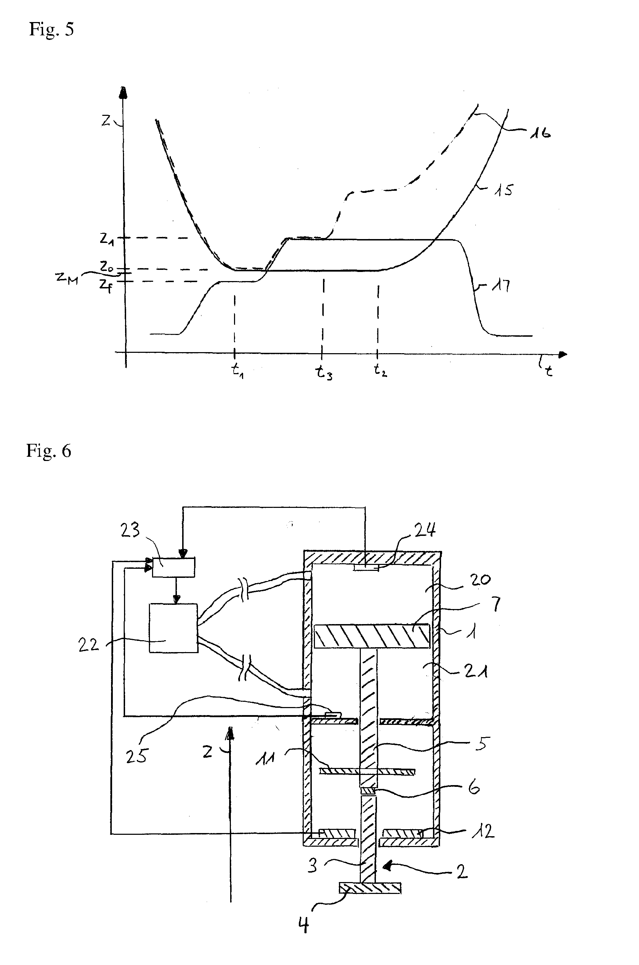

Bei einer Weiterentwicklung dieses Verfahrens, das anhand der Fig. 5 erläutert wird, ist ein weiterer Verfahrensschritt vorgesehen, der durchgeführt wird, nachdem die Nadel 14 ihre maximale Höhe $z_1$ erreicht hat und bevor die Auslenkung des Chipgreifers 2 gegenüber dem Bondkopf 1 den Wert Null erreicht. Dieser Verfahrensschritt besteht darin, die Druckkammer 8 mit Vakuum zu beaufschlagen, sobald sich der Halbleiterchip 19 ausreichend von der Folie 18 gelöst hat. In der Fig. 5 geschieht dies am Zeitpunkt $t_3$, an dem die Nadel 14 bereits ihre Soll-Höhe $z_1$ erreicht hat, aber vor dem Zeitpunkt $t_2$, an dem der Bondkopf 1 wieder angehoben wird. Dies führt dazu, dass der Kolben 7 und damit auch der Chipgreifer 2 mit im Vergleich zum Beispiel gemäss der Fig. 3 markant grösserer Geschwindigkeit von der Nadel 14 wegbewegt werden, wobei der Kolben 7 an einem oberen Anschlag des Bondkopfs 1 zum Anschlag kommt. Die Ablösung des Halbleiterchips 19 von der Nadel 14 erfolgt dabei kontrolliert und schnell. Dies vermindert die Gefahr, dass der Halbleiterchip 19 beim Ablösen von der Nadel 14 noch verschoben oder gedreht wird.

Da der Touch Down Sensor im Bondkopf 1 integriert ist, ist es möglich, die Auslenkung des Chipgreifers 2 gegenüber dem Bondkopf 1 bei jedem Aufnehmen eines Halbleiterchips 19 zu einem geeigneten Zeitpunkt zu messen und daraus die tatsächliche Höhe $z_{ist}$ der Oberfläche des aufgenommenen Halbleiterchips, die er vor der Aufnahme hatte, zu berechnen. Der geeignete Zeitpunkt ist nach dem Zeitpunkt $t_1$, wenn einerseits der Bondkopf auf der Höhe $z_0$ zum Stillstand gekommen ist und andererseits die Nadel 14 ihre Soll-Höhe $z_1$ erreicht hat. Das Mass der Auslenkung des Chipgreifers 2 hängt von der tatsächlich eingenommenen Höhe $z_0$ des Bondkopfs 1 ab. Die Höhe $z_0$ kann nun an bestimmten Zeitpunkten aktualisiert werden, indem ein neuer Wert $z_0'$ für die Soll-Höhe berechnet wird:

$$z_0' = z_{ist} + \Delta z. \qquad (2)$$

Die Aktualisierung der Höhe $z_0$ auf Grund des Wertes $z_0'$ erfolgt bevorzugt mittels in der Statistik üblichen Methoden, damit eine möglicherweise fehlerbehaftete Einzelmessung nicht zu einer Verschlechterung des Pick Prozesses führt.

Bei einem weiteren, als Overtravel bezeichneten Verfahren, wird die Höhe $z_0$ so ermittelt, dass sie um eine vorbestimmte Overtraveldistanz $\Delta z_1$ kleiner ist als die mittlere Höhe $z_M$ der Oberfläche der Halbleiterchips: $z_0 = z_M - \Delta z_1$. Die Overtraveldistanz $\Delta z_1$ ist so gewählt, dass die Höhe $z_0$ kleiner ist als die kleinste erwartete Höhe der Oberfläche der Halbleiterchips 19. Der Bondkopf 1 wird mit maximaler Geschwindigkeit abgesenkt und auf der Höhe $z_0$ zum Stillstand gebracht. Der Chipgreifer 2 wird ab dem Zeitpunkt des Aufpralls auf den Halbleiterchip 19 gegenüber dem Bondkopf 1 zunehmend ausgelenkt und übt die durch den in der Druckkammer 8 angelegten Druck definierte Pickkraft auf den Halbleiterchip 19 aus. Die verbesserte Kenntnis der z-Höhe der Oberfläche der Halbleiterchips 19 und die infolge der pneumatischen Lagerung des Chipgreifers 2 wegunabhängige Pickkraft ermöglichen es, die Overtraveldistanz $\Delta z_1$ viel kleiner als beim Stand der Technik zu halten. Eine kleinere Overtraveldistanz $\Delta z_1$ bedeutet, dass der Chipgreifer 2 erst in der allerletzten Phase des Absenkens auf den Halbleiterchip 19 auftrifft, wo der Bondkopf 1 bereits stark abgebremst und seine Geschwindigkeit beim Auftreffen sehr klein ist.

Bei den bisher beschriebenen Beispielen erfolgt das Absenken des Chipgreifers 2 während des Verfahrensschrittes a indirekt, in dem der Chipgreifer 2 bezüglich des Bondkopfs 1 in eine Endlage, nämlich seine Ruhelage, gebracht wird und der Bondkopf 1 bzw. das ganze Pick und Placesystem mit dem Bondkopf 1 abgesenkt wird. Beim folgenden Beispiel ist hingegen der Bondkopf 1 in der z-Richtung nicht bewegbar. Dafür ist ein Antrieb vorhanden, der die z-Lage des Chipgreifers 2 direkt steuert.

Die Fig. 6 zeigt einen Bondkopf 1 mit einem pneumatischen Antrieb für den Chipgreifer 2. Bei diesem Ausführungsbeispiel befindet sich die Spule 12 unterhalb der metallischen Platte 11. Der pneumatische Antrieb umfasst zwei Druckkammern 20 und 21, die über Leitungen mit einem Ventilsystem 22, das mit Druckluft versorgt wird, verbunden sind. Das Ventilsystem 22 wird von einem Regler 23 gesteuert. Der aus der metallischen Platte 11 und der Spule 12 bestehende induktive Sensor dient nicht nur als Touch Down Sensor, sondern als Wegaufnehmer 29 für die Messung der Auslenkung des Chipgreifers 9 bezüglich des stationär angeordneten Bondkopfs 1 in z-Richtung. Ein erster Drucksensor 24 dient zur Messung des in der ersten Druckkammer 20 herrschenden Druckes $p_1$, ein zweiter Drucksensor 25 dient zur Messung des in der zweiten Druckkammer 21 herrschenden Druckes $p_2$. Die Ausgangssignale des induktiven Sensors bzw. der beiden Drucksensoren 24 und 25 werden dem Regler 23 als Eingangsgrössen zugeführt. Der Regler 23 liefert Steuersignale für die Steuerung des Ventilsystems 22. Der Regler 23 arbeitet in zwei Betriebsarten. In der ersten Betriebsart wird die Auslenkung des Chipgreifers 2, also die z-Position, oder eine davon abgeleitete Grösse geregelt. Der induktive Sensor liefert in Funktion der Zeit t ein der Auslenkung $z_{ist}(t)$ proportionales Signal und der Regler 23 steuert die Ventile des Ventilsystems 22 gemäss einem vorgegebenen Verlauf $z_{soll}(t)$. In der zweiten Betriebsart wird die Druckdifferenz $p_1 - p_2$ geregelt, die die vom Chipgreifer 2 aufzubringende Bondkraft erzeugt. Weitere Angaben zu einem solchen Bondkopf können der europäischen Patentanmeldung Nr. 01204781.7 entnommen werden, auf die hiermit explizit verwiesen wird.

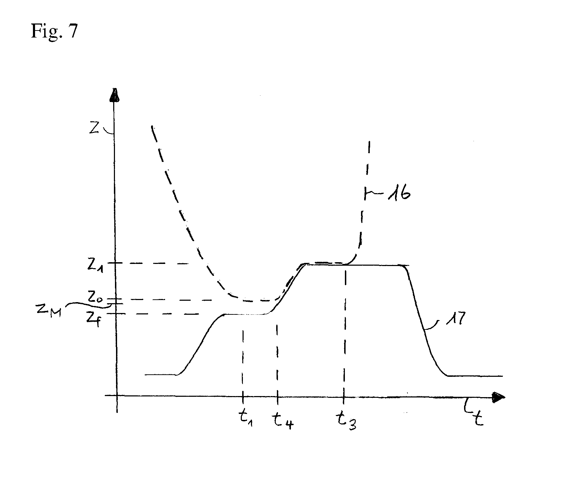

Im folgenden wird nun anhand der Fig. 7 beschrieben, wie der Pickprozess mit diesem Bondkopf 1 durchgeführt wird. Die Höhe $z_0$ ist wiederum gegeben durch Gleichung (1). Die gestrichelte Linie 16 zeigt den zeitlichen Verlauf der z-Höhe des Chipgreifers 2. Die ausgezogene Linie 17 zeigt den zeitlichen Verlauf der z-Höhe der Nadel 14.

In der ersten Phase, die bis zum Zeitpunkt $t_1$ dauert, wird der Chipgreifer 2 mit maximaler Geschwindigkeit abgesenkt, dabei möglichst spät abgebremst und, ohne den Halbleiterchip 19 zu berühren, auf der Höhe $z_0$ zum Stillstand gebracht. Der Regler 23 arbeitet dabei in der ersten Betriebsart, in der er die Auslenkung des Chipgreifers 2, also die z-Position, oder eine davon abgeleitete Grösse regelt. Die Nadel 14 (Fig. 4A) wird soweit angehoben, dass sie die Unterseite der Folie 18 gerade berührt.

In der zweiten Phase, die vom Zeitpunkt $t_1$ bis zum Zeitpunkt $t_4$ dauert, verharrt der Chipgreifer 2 zunächst auf der Höhe $z_0$. Die Nadel 14 wird mit kontrollierter Geschwindigkeit angehoben, bis sie eine vorbestimmte Höhe $z_1$ erreicht. Dabei durchstösst die Nadel 14 die Folie 18 und hebt den Halbleiterchip 19 an. Der Halbleiterchip 19 kommt am Zeitpunkt $t_4$ zunächst in Kontakt mit dem Chipgreifer 2 und lenkt dann den Chipgreifer 2 gegenüber dem Bondkopf 1 aus: Der Halbleiterchip 19 ist nun zwischen dem Chipgreifer 2 und der Nadel 14 eingeklemmt. Sobald der Chipgreifer 2 gegenüber dem Bondkopf 1 ausgelenkt wird, ändert sich das Ausgangssignal des induktiven Sensors, worauf der Regler 23 den in der ersten Druckkammer 20 herrschenden Druck $p_1$ erhöhen müsste, um die z-Höhe des Chipgreifers 2 weiterhin konstant auf der Höhe $z_0$ zu halten. Weil aber andererseits die Nadel 14 die Höhe $z_1$ erreichen muss, muss eine Änderung der z-Höhe des Chipgreifers 2 möglich und erlaubt sein. Dies kann auf verschiedene Arten ermöglicht werden.

Eine erste Möglichkeit besteht darin, die maximal erlaubte Druckdifferenz $p_1 - p_2$ zu begrenzen und zwar auf einen Wert, der der aufzubringenden Pickkraft entspricht. Der Regler 23 arbeitet also weiterhin in der ersten Betriebsart, wobei die erlaubte Druckdifferenz $p_1 - p_2$ begrenzt wird, entweder ab dem Zeitpunkt $t_1$, an dem der Chipgreifer 2 die Höhe $z_0$ erreicht hat oder ab dem Zeitpunkt, an dem die Nadel 14 angehoben wird. (Während des Absenkens des Chipgreifers muss die Druckdifferenz $p_1 - p_2$ nicht begrenzt werden.) Der Regler 23 versucht, den Chipgreifer 2 auf der Höhe $z_0$ zu halten. Da aber die Druckdifferenz $p_1 - p_2$ auf die Pickkraft begrenzt ist, vermag er der Kraft der Nadel 14 nicht zu widerstehen. Der Chipgreifer 2 wird deshalb angehoben.

Eine zweite Möglichkeit besteht darin, den Regler 23 von der ersten Betriebsrat in die zweite Betriebsart zu wechseln, sobald nach dem Start des Anhebens der Nadel 14 das Ausgangssignal des induktiven Sensors um mehr als einen vorbestimmten Wert ändert, was als Beginn der Auslenkung des Chipgreifers 2 interpretiert werden kann. In der zweiten Betriebsart wird die Druckdifferenz $p_1 - p_2$ entsprechend der aufzubringenden Pickkraft geregelt.

In der dritten Phase, die am Zeitpunkt $t_3$ beginnt, werden die Druckkammer 20 mit Vakuum und die Druckkammer 21 mit Überdruck beaufschlagt, um den Chipgreifer 2 schlagartig abzuheben, bis der Kolben 7 an einer oberen Position geregelt wird oder an einem oberen Anschlag zur Ruhe kommt, wobei sich der Halbleiterchip 19 von der Nadel 14 löst, und dann der Bondkopf 1 in horizontaler Richtung wegbewegt, um den Halbleiterchip 19 auf dem Substrat zu platzieren. Der Regler 23 arbeitet dabei entweder in der ersten Betriebsart, in der er die z-Lage des Chipgreifers 2 regelt, oder in der zweiten Betriebsart, in der die Druckdifferenz $p_1 - p_2$ so geregelt wird, dass der Chipgreifer 2 nach oben bewegt wird, bis der Kolben 7 an einem oberen Anschlag gestoppt wird.

## Patentansprüche

1. Verfahren zum Aufnehmen eines Halbleiterchips (19) von einer Folie (18), wobei der Halbleiterchip (19) von einem Chipgreifer (2) aufgenommen wird, der an einem Bondkopf (1) in einer z-Richtung verschiebbar gelagert ist, und wobei das Ablösen des Halbleiterchips (19) von der Folie (18) mit der Unterstützung einer Nadel (14) erfolgt, **gekennzeichnet durch** die folgenden Schritte:

   a) Absenken des Chipgreifers (2) auf eine Position $z_0$, die grösser ist als eine mittlere Höhe der Oberfläche der Halbleiterchips (19), damit der Chipgreifer (2) den Halbleiterchip (19) noch nicht berührt,
   b) Anheben der Nadel (14) auf eine vorbestimmte Position $z_1$, wobei die Nadel (14) den Halbleiterchip (19) anhebt, um den Halbleiterchip (19) in Kontakt mit dem Chipgreifer (2) zu bringen und dann die z-Position des Chipgreifers (2) zu erhöhen, und
   c) Anheben des Chipgreifers (2), wobei sich der Halbleiterchip (19) von der Nadel (14) löst.

2. Verfahren nach Anspruch 1, **dadurch gekennzeichnet, dass** der Chipgreifer (2) mit einem pneumatisch am Bondkopf (1) gelagerten, in der z-Richtung verschiebbaren Kolben (7) verbunden ist, wobei die Lage des Kolbens (7) und damit die z-Lage des Chipgreifers (2) mittels eines in einer Druckkammer (8) herrschenden Druckes gesteuert wird, dass ein Antrieb vorhanden ist, um den Bondkopf (1) in der z-Richtung zu bewegen, wobei im Schritt a die Druckkammer (8) mit einem vorbestimmten Druck beaufschlagt wird, so dass der Chipgreifer (2) eine Endlage einnimmt, wobei im Schritt a der Bondkopf (1) abgesenkt wird und wobei im Schritt b das Anheben der Nadel (14) bewirkt, dass der Chipgreifer (2) aus der Endlage wegbewegt wird.

3. Verfahren nach Anspruch 2, **dadurch gekennzeichnet, dass** im Schritt c die Druckkammer (8) mit Vakuum beaufschlagt wird, um den Halbleiterchip (19) schlagartig von der Nadel (14) zu lösen.

4. Verfahren nach Anspruch 1, bei dem der Bondkopf (1) bezüglich der z-Richtung stationär angeordnet ist und bei dem der Chipgreifer (2) mittels eines durch zwei Druckkammern (20, 21) und einen Kolben (7) gebildeten pneumatischen Antriebs in der z-Richtung bewegbar ist.

5. Verfahren nach einem der Ansprüche 1 bis 4, **dadurch gekennzeichnet, dass** die z-Lage des Chipgreifers (2) nach dem Schritt b gemessen wird, um die tatsächliche z-Höhe der Oberfläche des aufgenommenen Halbleiterchips (19) zu bestimmen, und dass die Position $z_0$ an bestimmten Zeitpunkten aktualisiert wird.

6. Verfahren nach Anspruch 5, **dadurch gekennzeichnet, dass** die z-Position des Chipgreifers (2) mittels eines im Bondkopf (1) integrierten induktiven Sensors (11, 12) gemessen wird.

7. Verfahren nach einem der Ansprüche 1 bis 6, **dadurch gekennzeichnet, dass** im Schritt a das Absenken des Chipgreifers (2) auf eine Position $z_0$ erfolgt, die kleiner ist als eine mittlere Höhe der Oberfläche der Halbleiterchips (19), so dass der Chipgreifer (2) beim Auftreffen auf den Halbleiterchip (19) gegenüber dem Bondkopf (1) ausgelenkt wird, dass der Chipgreifer (2) pneumatisch am Bondkopf (1) gelagert ist, und dass im Bondkopf (1) ein induktiver Sensor (11, 12) integriert ist, um die z-Position des Chipgreifers (2) messen zu können.

**8.** Die Bonder mit einem Bondkopf (1), wobei der Bondkopf (1) einen in einer vorbestimmten Richtung auslenkbaren Chipgreifer (2) aufweist, **dadurch gekennzeichnet, dass** der Bondkopf (1) einen induktiven Sensor (11, 12) für die Messung der Lage des Chipgreifers (2) gegenüber dem Bondkopf (1) aufweist.

**9.** Die Bonder nach Anspruch 5, **dadurch gekennzeichnet, dass** der induktive Sensor (11, 12) eine Flachspule (12) aufweist.

Fig. 1

Fig. 2

Fig. 3

Fig. 4A

Fig. 4B

Fig. 4C

Fig. 5

Fig. 6

Fig. 7

**Europäisches Patentamt**

# EUROPÄISCHER RECHERCHENBERICHT

Nummer der Anmeldung

EP 02 08 0020

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int.Cl.7) |
|---|---|---|---|
| X | US 5 351 872 A (KOBAYASHI HIROAKI) 4. Oktober 1994 (1994-10-04) * Zusammenfassung; Abbildungen 3,8 * * Spalte 1, Zeile 13 - Spalte 5, Zeile 12 * | 1,5 | H01L21/00 H05K13/04 |
| Y | | 8,9 | |
| X | PATENT ABSTRACTS OF JAPAN vol. 1998, no. 12, 31. Oktober 1998 (1998-10-31) -& JP 10 189690 A (HITACHI LTD;AKITA DENSHI KK), 21. Juli 1998 (1998-07-21) * Zusammenfassung * | 1 | |
| A | PATENT ABSTRACTS OF JAPAN vol. 1999, no. 14, 22. Dezember 1999 (1999-12-22) -& JP 11 260840 A (MATSUSHITA ELECTRIC IND CO LTD), 24. September 1999 (1999-09-24) * Zusammenfassung * | 1,4 | |
| A | PATENT ABSTRACTS OF JAPAN vol. 013, no. 235 (E-766), 30. Mai 1989 (1989-05-30) -& JP 01 041230 A (MITSUBISHI ELECTRIC CORP), 13. Februar 1989 (1989-02-13) * Zusammenfassung * | 2 | **RECHERCHIERTE SACHGEBIETE (Int.Cl.7)** H01L H05K |
| A | EP 1 187 181 A (ESEC TRADING S A) 13. März 2002 (2002-03-13) * Zusammenfassung; Ansprüche; Abbildungen * | 2 | |
| Y | EP 1 248 076 A (ESEC TRADING S A) 9. Oktober 2002 (2002-10-09) * das ganze Dokument * | 8,9 | |

-/--

Der vorliegende Recherchenbericht wurde für alle Patentansprüche erstellt

| Recherchenort | Abschlußdatum der Recherche | Prüfer |
|---|---|---|
| BERLIN | 1. September 2003 | Hamdani, F |

EPO FORM 1503 03.82 (P04C03)

**Europäisches Patentamt**

## EUROPÄISCHER RECHERCHENBERICHT

Nummer der Anmeldung

EP 02 08 0020

| | EINSCHLÄGIGE DOKUMENTE | | |
|---|---|---|---|
| Kategorie | Kennzeichnung des Dokuments mit Angabe, soweit erforderlich, der maßgeblichen Teile | Betrifft Anspruch | KLASSIFIKATION DER ANMELDUNG (Int.Cl.7) |
| A | WO 02 01159 A (KINDLER ULRICH) 3. Januar 2002 (2002-01-03) * das ganze Dokument * ----- | 8,9 | |
| | | | **RECHERCHIERTE SACHGEBIETE (Int.Cl.7)** |

Der vorliegende Recherchenbericht wurde für alle Patentansprüche erstellt

| Recherchenort | Abschlußdatum der Recherche | Prüfer |
|---|---|---|
| BERLIN | 1. September 2003 | Hamdani, F |

KATEGORIE DER GENANNTEN DOKUMENTE

X : von besonderer Bedeutung allein betrachtet
Y : von besonderer Bedeutung in Verbindung mit einer anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder nach dem Anmeldedatum veröffentlicht worden ist
D : in der Anmeldung angeführtes Dokument
L : aus anderen Gründen angeführtes Dokument

....................................................................
& : Mitglied der gleichen Patentfamilie, übereinstimmendes Dokument

EPO FORM 1503 03.82 (P04C03)

**Europäisches
Patentamt**

---

## GEBÜHRENPFLICHTIGE PATENTANSPRÜCHE

Die vorliegende europäische Patentanmeldung enthielt bei ihrer Einreichung mehr als zehn Patentansprüche.

☐ Nur ein Teil der Anspruchsgebühren wurde innerhalb der vorgeschriebenen Frist entrichtet. Der vorliegende europäische Recherchenbericht wurde für die ersten zehn sowie für jene Patentansprüche erstellt, für die Anspruchsgebühren entrichtet wurden, nämlich Patentansprüche:

☐ Keine der Anspruchsgebühren wurde innerhalb der vorgeschriebenen Frist entrichtet. Der vorliegende europäische Recherchenbericht wurde für die ersten zehn Patentansprüche erstellt.

## MANGELNDE EINHEITLICHKEIT DER ERFINDUNG

Nach Auffassung der Recherchenabteilung entspricht die vorliegende europäische Patentanmeldung nicht den Anforderungen an die Einheitlichkeit der Erfindung und enthält mehrere Erfindungen oder Gruppen von Erfindungen, nämlich:

Siehe Ergänzungsblatt B

☒ Alle weiteren Recherchengebühren wurden innerhalb der gesetzten Frist entrichtet. Der vorliegende europäische Recherchenbericht wurde für alle Patentansprüche erstellt.

☐ Da für alle recherchierbaren Ansprüche die Recherche ohne einen Arbeitsaufwand durchgeführt werden konnte, der eine zusätzliche Recherchengebühr gerechtfertigt hätte, hat die Recherchenabteilung nicht zur Zahlung einer solchen Gebühr aufgefordert.

☐ Nur ein Teil der weiteren Recherchengebühren wurde innerhalb der gesetzten Frist entrichtet. Der vorliegende europäische Recherchenbericht wurde für die Teile der Anmeldung erstellt, die sich auf Erfindungen beziehen, für die Recherchengebühren entrichtet worden sind, nämlich Patentansprüche:

☐ Keine der weiteren Recherchengebühren wurde innerhalb der gesetzten Frist entrichtet. Der vorliegende europäische Recherchenbericht wurde für die Teile der Anmeldung erstellt, die sich auf die zuerst in den Patentansprüchen erwähnte Erfindung beziehen, nämlich Patentansprüche:

**Europäisches**
**Patentamt**

**MANGELNDE EINHEITLICHKEIT**
**DER ERFINDUNG**
**ERGÄNZUNGSBLATT B**

Nummer der Anmeldung

EP 02 08 0020

Nach Auffassung der Recherchenabteilung entspricht die vorliegende europäische Patentanmeldung nicht den Anforderungen an die Einheitlichkeit der Erfindung und enthält mehrere Erfindungen oder Gruppen von Erfindungen, nämlich:

1. Ansprüche: 1-7

   Verfahren zum Aufnehmen eines Halbleiterchips von einer Folie.

2. Ansprüche: 8,9

   Die Bonder mit einen induktiven Sensor.

16

**ANHANG ZUM EUROPÄISCHEN RECHERCHENBERICHT**
**ÜBER DIE EUROPÄISCHE PATENTANMELDUNG NR.**    EP 02 08 0020

In diesem Anhang sind die Mitglieder der Patentfamilien der im obengenannten europäischen Recherchenbericht angeführten
Patentdokumente angegeben.
Die Angaben über die Familienmitglieder entsprechen dem Stand der Datei des Europäischen Patentamts am
Diese Angaben dienen nur zur Unterrichtung und erfolgen ohne Gewähr.

01-09-2003

| Im Recherchenbericht angeführtes Patentdokument | | Datum der Veröffentlichung | Mitglied(er) der Patentfamilie | | Datum der Veröffentlichung |
|---|---|---|---|---|---|
| US 5351872 | A | 04-10-1994 | JP | 2635889 B2 | 30-07-1997 |
| | | | JP | 6013416 A | 21-01-1994 |
| | | | KR | 9615922 B1 | 23-11-1996 |
| JP 10189690 | A | 21-07-1998 | KEINE | | |
| JP 11260840 | A | 24-09-1999 | JP | 3132496 B2 | 05-02-2001 |
| JP 01041230 | A | 13-02-1989 | KEINE | | |
| EP 1187181 | A | 13-03-2002 | EP | 1187180 A1 | 13-03-2002 |
| | | | EP | 1187181 A2 | 13-03-2002 |
| | | | JP | 2002118125 A | 19-04-2002 |
| EP 1248076 | A | 09-10-2002 | EP | 1248076 A1 | 09-10-2002 |
| WO 0201159 | A | 03-01-2002 | DE | 20011223 U1 | 05-10-2000 |
| | | | CN | 1439092 T | 27-08-2003 |
| | | | WO | 0201159 A1 | 03-01-2002 |
| | | | EP | 1295089 A1 | 26-03-2003 |
| | | | US | 2003151402 A1 | 14-08-2003 |

EPO FORM P0461

Für nähere Einzelheiten zu diesem Anhang : siehe Amtsblatt des Europäischen Patentamts, Nr.12/82